# EUROPEAN PATENT APPLICATION

(11) **EP 4 654 802 A1**
(43) Date of publication of application: **26.11.2025**
(21) Application number: 24823516.0
(22) Date of filing: 06.03.2024
(51) Int. Cl.: H10K 59/80, H10K 59/35, H10K 77/10, H10K 59/38, H10K 59/131, H10K 59/122, H10K 102/00

(54) **DISPLAY INCLUDING OPAQUE MATERIAL FOR REDUCING AMOUNT OF LIGHT AND ELECTRONIC DEVICE INCLUDING SAME**

(30) Priority: 14.06.2023 KR 20230076283; 19.07.2023 KR 20230093736
(71) Applicant: Samsung Electronics Co., Ltd., Suwon-si, Gyeonggi-do 16677 (KR)
(72) Inventor: HER, Yongkoo, Suwon-si Gyeonggi-do 16677 (KR); KIM, Nari, Suwon-si Gyeonggi-do 16677 (KR); PARK, Jaewook, Suwon-si Gyeonggi-do 16677 (KR); LEE, Eungyeong, Suwon-si Gyeonggi-do 16677 (KR); SHIN, Jungwoon, Suwon-si Gyeonggi-do 16677 (KR)
(74) Representative: Gulde & Partner
(86) International application number: PCT/KR2024/002877
(87) International publication number: WO 2024/257994

(57) **Abstract**

A display is provided. According to an embodiment, the display comprises: a substrate; a light-emitting layer including a plurality of first light-emitting elements and at least one second light-emitting element and disposed on the substrate; a plurality of first transmission members disposed on the plurality of first light-emitting elements, respectively, and configured to refract first light from each of the plurality of first light-emitting elements; at least one second transmission member disposed on the at least one second light-emitting element and configured to transmit second light from the at least one second light-emitting element; and a blocking member including an opaque material and in contact with the at least one second transmission member, wherein the shape of the at least one second transmission member is different from the shape of each of the plurality of first transmission members.

## Description

### [TECHNICAL FIELD]

The present disclosure relates to a display including an opaque material for reducing an amount of light and an electronic device including the same.

### [BACKGROUND ART]

An electronic device may provide various contents to a user through a display. The electronic device may display content on the display through a processor and/or a display driving circuit. While displaying the content through the processor and/or the display driving circuit, quality of different content may vary according to a structure in the display.

The above information is presented as a related art only to assist with an understanding of the disclosure. No determination has been made, and no assertion is made, as to whether any of the above might be applicable as a prior art with regard to the disclosure.

### [DISCLOSURE]

### [Technical Solution]

Aspects of the disclosure are to address at least the above-mentioned problems and/or disadvantages and to provide at least the advantages described below. Accordingly, an aspect of the disclosure is to provide a display including an opaque material for reducing an amount of light and an electronic device including the same.

Additional aspects will be set forth in part in the description which follows and, in part, will be apparent from the description, or may be learned by practice of the presented embodiments.

A display is provided. According to an embodiment, the display may comprise a substrate. According to an embodiment, the display may comprise a plurality of first light emitting elements and at least one second light emitting element and may be disposed on a light emitting layer disposed on the substrate and each of the plurality of first light emitting elements. According to an embodiment, the display may comprise a plurality of first transmission members configured to refract a first light from each of the plurality of first light emitting elements. According to an embodiment, the display may comprise at least one second transmission member disposed on the at least one second light emitting element and configured to transmit a second light from the at least one second light emitting element. According to an embodiment, the display may comprise a blocking member including opaque material for absorbing at least a portion of the second light transmitted to an outside of the display, and contacting the at least one second transmission member. According to an embodiment, a shape of the at least one second transmission member may be different from a shape of each of the plurality of first transmission members.

An electronic device is provided. According to an embodiment, the electronic device may comprise a housing. According to an embodiment, the electronic device may comprise a display disposed on the housing. According to an embodiment, the display may include a substrate. According to an embodiment, the display may include a plurality of first light emitting elements and at least one second light emitting element and may be disposed on a light emitting layer disposed on the substrate and each of the plurality of first light emitting elements. According to an embodiment, the display may include a plurality of first transmission members configured to refract a first light from each of the plurality of first light emitting elements. According to an embodiment, the display may include at least one second transmission member disposed on the at least one second light emitting element and configured to transmit a second light from the at least one second light emitting element. According to an embodiment, the display may include a blocking member including opaque material for absorbing at least a portion of the second light transmitted to an outside of the display, and contacting the at least one second transmission member. According to an embodiment, a volume of the at least one second transmission member may be different from a volume of each of the plurality of first transmission members.

Other aspects, advantages, and salient features of the disclosure will become apparent to those skilled in the art from the following detailed description, which, taken in conjunction with the annexed drawings, discloses various embodiments of the disclosure.

### [DESCRIPTION OF THE DRAWINGS]

FIG. 1 is a block diagram of an electronic device in a network environment according to various embodiments.
FIG. 2 is a block diagram of a display module according to various embodiments.
FIG. 3 illustrates an exemplary electronic device according to an embodiment.
FIG. 4 is a cross-sectional view illustrating an example of cutting an exemplary display along A-A' of FIG. 3 according to an embodiment.
FIG. 5 illustrates an example of a method of manufacturing an exemplary display according to an embodiment.
FIG. 6 is a cross-sectional view illustrating an example of cutting an exemplary display according to an embodiment.
FIG. 7 is a cross-sectional view illustrating an example of cutting an exemplary display according to an embodiment.
FIG. 8 is a cross-sectional view illustrating an example of cutting an exemplary display according to an embodiment.
FIG. 9 is a cross-sectional view illustrating an example of cutting an exemplary display according to an embodiment.
FIG. 10 is a cross-sectional view illustrating an example of cutting an exemplary display according to an embodiment.
FIG. 11 is a cross-sectional view illustrating an example of cutting an exemplary display according to an embodiment.
FIG. 12 is a cross-sectional view illustrating an example of cutting an exemplary display according to an embodiment.
FIG. 13 is a cross-sectional view illustrating an example of cutting an exemplary display according to an embodiment.

### [MODE FOR INVENTION]

The following description with reference to the accompanying drawings is provided to assist in a comprehensive understanding of various embodiments of the disclosure as defined by the claims and their equivalents. It includes various specific details to assist in that understanding but these are to be regarded as merely exemplary. Accordingly, those of ordinary skill in the art will recognize that various changes and modifications of the various embodiments described herein can be made without departing from the scope and spirit of the disclosure. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims and their equivalents.

It should be appreciated that the blocks in each flowchart and combinations of the flowcharts may be performed by one or more computer programs which include instructions. The entirety of the one or more computer programs may be stored in a single memory or the one or more computer programs may be divided with different portions stored in different multiple memories.

Any of the functions or operations described herein can be processed by one processor or a combination of processors. The one processor or the combination of processors is circuitry performing processing and includes circuitry like an application processor (AP, e.g. a central processing unit (CPU)), a communication processor (CP, e.g., a modem), a graphical processing unit (GPU), a neural processing unit (NPU) (e.g., an artificial intelligence (AI) chip), a Wi-Fi chip, a Bluetooth^{®} chip, a global positioning system (GPS) chip, a near field communication (NFC) chip, connectivity chips, a sensor controller, a touch controller, a fingerprint sensor controller, a display driver integrated circuit (IC) (DDI), an audio CODEC chip, a universal serial bus (USB) controller, a camera controller, an image processing IC, a microprocessor unit (MPU), a system on chip (SoC), an integrated circuit (IC), or the like.

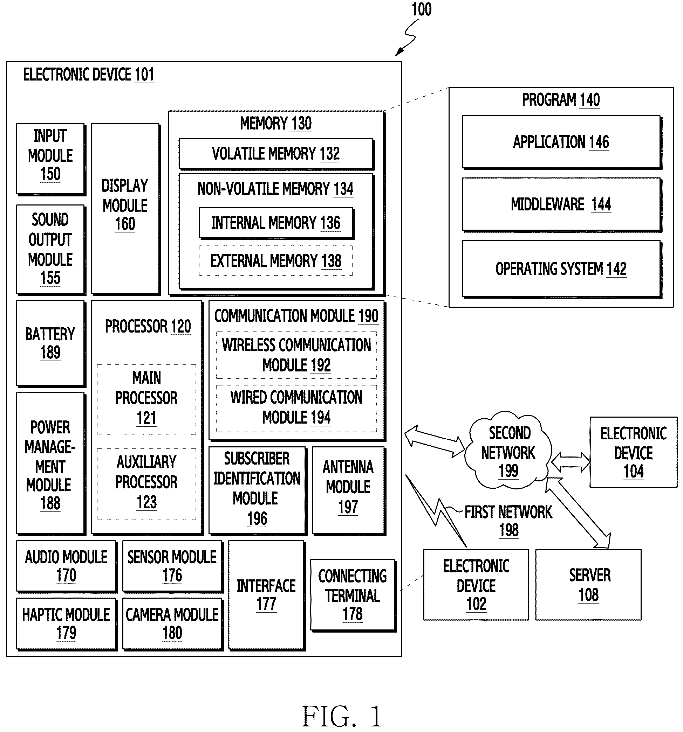

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a fourth generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the millimeter wave (mmWave) band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

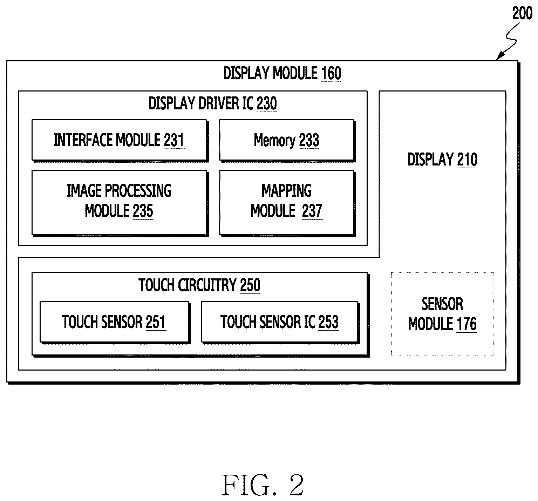

FIG. 2 is a block diagram 200 of a display module 160 according to various embodiments.

Referring to FIG. 2, the display module 160 may include a display 210 and a display driver IC (DDI) 230 for controlling the display 210. The DDI 230 may include an interface module 231, memory 233 (e.g., a buffer memory), an image processing module 235, or a mapping module 237. The DDI 230 may receive, for example, image information including image data or an image control signal corresponding to a command for controlling the image data from other components of an electronic device 101 through the interface module 231. For example, according to an embodiment, the image information may be received from the processor 120 (e.g., a main processor 121 (e.g., an application processor)) or an auxiliary processor 123 (e.g., a graphic processing device) that operates independently of a function of the main processor 121. The DDI 230 may communicate with a touch circuit 250 or a sensor module 176 or the like through the interface module 231. In addition, the DDI 230 may store at least a portion of the received image information in the memory 233, for example, in units of frames. The image processing module 235 may, for example, perform pre-processing or post-processing (e.g., adjust resolution, brightness, or size) at least a portion of the image data based at least on a characteristic of the image data or a characteristic of the display 210. The mapping module 237 may generate a voltage value or a current value corresponding to the image data pre-processed or post-processed through the image processing module 235. According to an embodiment, generation of the voltage value or the current value may, for example, be performed based at least partially on properties of pixels of the display 210 (e.g., array of pixels (red green blue (RGB) stripe or pentile structure), or a size of each subpixel). Visual information (e.g., text, image, or icon) corresponding to the image data may be displayed through the display 20 as at least a portion of the pixels of the display 210 is driven, for example, based at least partially on the voltage value or current value.

According to an embodiment, the display module 160 may further include the touch circuit 250. The touch circuit 250 may include a touch sensor 251 and a touch sensor IC 253 for controlling the touch sensor 251. The touch sensor IC 253 may control the touch sensor 251 to detect, for example, a touch input or a hovering input for a specific position of the display 210. For example, the touch sensor IC 253 may detect the touch input or the hovering input by measuring a change in a signal (e.g., voltage, light amount, resistance, or charge amount) for the specific position of the display 210. The touch sensor IC 253 may provide information (e.g., position, area, pressure, or time) on the detected touch input or hovering input to the processor 120. According to an embodiment, at least a portion of the touch circuit 250 (e.g., the touch sensor IC 253) may be included as a portion of the DDI 230 or the display 210, or as a portion of another component (e.g., the auxiliary processor 123) disposed outside the display module 160.

According to an embodiment, the display module 160 may further include at least one sensor (e.g., a fingerprint sensor, an iris sensor, a pressure sensor, or an illuminance sensor) of the sensor module 176, or a control circuit therefor. In this case, the at least one sensor or the control circuit therefor may be embedded in a portion of the display module 160 (e.g., the display 210 or the DDI 230) or a portion of the touch circuit 250. For example, in case that the sensor module 176 embedded in the display module 160 includes a biometric sensor (e.g., a fingerprint sensor), the biometric sensor may obtain biometric information (e.g., a fingerprint image) associated with a touch input through a partial area of the display 210. For another example, in case that the sensor module 176 embedded in the display module 160 includes a pressure sensor, the pressure sensor may obtain pressure information associated with the touch input through a portion or entire area of the di"play'210. According to an embodiment, the touch sensor 251 or the sensor module 176 may be disposed between pixels of a pixel layer of the display 210, or above or below the pixel layer.

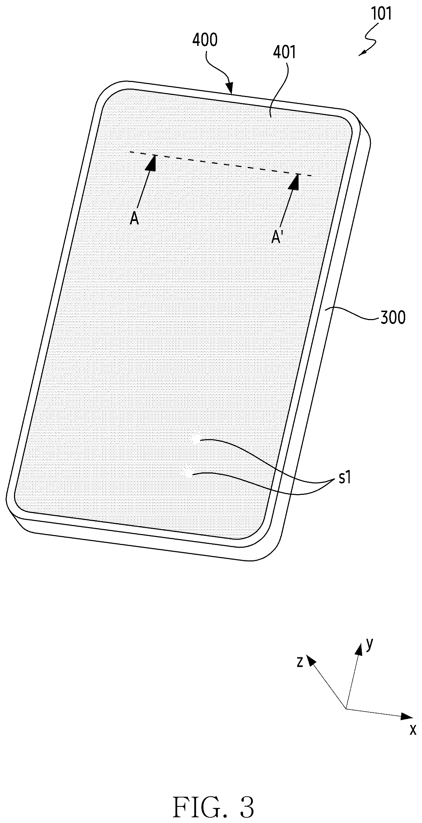

FIG. 3 illustrates an exemplary electronic device according to an embodiment.

Referring to FIG. 3, an electronic device 101 according to an embodiment may include a housing 300 and/or a display 400 (e.g., the display module 160 of FIG. 1 and/or the display 210 of FIG. 2). In FIG. 3, the electronic device 101 is illustrated as having a shape of a smartphone, but is not limited thereto. For example, the electronic device 101 may have a shape of a wearable device worn on a portion of a body of a user. For example, the wearable device may be configured to provide the user with augmented reality (AR), virtual reality (VR), and/or mixed reality (MR) that mixes augmented reality and virtual reality.

According to an embodiment, the housing 300 may provide at least a portion of an outer surface of the electronic device 101. For example, the housing 300 may define (or form) a side surface of the electronic device 101 and/or a rear surface of the electronic device 101. The housing 300 may accommodate components of the electronic device 101. The housing 300 may define (or form) a space in which components of the electronic device 101 may be accommodated (or disposed). The housing 300 may support at least a portion of the components of the electronic device 101. For example, the housing 300 may support the display 400.

According to an embodiment, the display 400 may be disposed on the housing 300. At least a portion of the display 400 may be exposed to an outside of the electronic device 101. For example, at least a portion of the display 400 may define (or form) at least a portion of a front surface of the electronic device 101. The display 400 may be configured to provide visual information. A (DDI) (e.g., the DDI 230 of FIG. 2) may display a screen 401 for providing visual information (or providing content) through the display 400. For example, the DDI 230 may display the screen 401 based on receiving data for displaying the screen 401 from a processor (e.g., the processor 120 of FIG. 1).

For example, while the screen 401 is displayed on the display 400, a bright spot s1 may be visible. The bright spot s1 may be referred to as a white spot. The bright spot s1 may be caused (or generated) by a defect in the display 400. For example, the bright spot s1 may not be included in content included in the data for displaying the screen 401 received from the processor 120 to the DDI 230. For example, the bright spot s1 may not be included in the content in the screen 401 that the DDI 230 wants to display. In other words, the bright spot s1 may not be intended by the processor 120 and/or the DDI 230. For example, while the DDI 230 controls the display 400 to display black on the entire area of the screen 401, one area of the screen 401 where the bright spot s1 is positioned may be configured to emit brighter light than another area of the screen 401 where the bright spot s1 is not positioned. For example, the brightness (or luminance) of the one area of the screen 401 where the bright spot s1 is positioned may be 5% or more than the brightness (or luminance) of the other area of the screen 401 where the bright spot s1 is not positioned, but is not limited thereto. In case that the bright spot s1 is included in the display 400, the display 400 may not smoothly provide visual information to the user. Hereinafter, a structure for compensating (or removing) the bright spot s1 of the display 400 will be described.

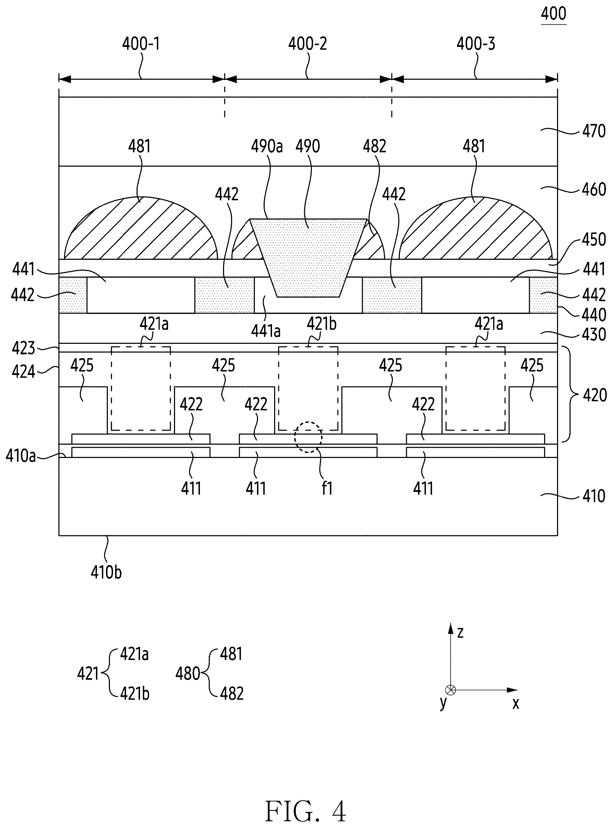

FIG. 4 is a cross-sectional view illustrating an example of cutting an exemplary display along A-A' of FIG. 3 according to an embodiment.

Referring to FIG. 4, a display 400 according to an embodiment may include a substrate 410, a light emitting layer 420, an encapsulation layer 430, a filter layer 440, a flattening layer 450, an adhesive layer 460, a cover layer 470, a plurality of transmission members 480, and/or a blocking member 490.

According to an embodiment, the substrate 410 may support various components included in the display 400. For example, the substrate 410 may support conductive lines 411. The conductive lines 411 may be disposed on the substrate 410. For example, the conductive lines 411 may form at least a portion of a plurality of thin film transistors (TFTs) for controlling driving of the display 400. For example, the plurality of TFTs may be formed based on low temperature polycrystalline silicon (LTPS) or low temperature polycrystalline oxide (LTPO). According to an embodiment, the substrate 410 may include a substantially opaque material. The substrate 410 may be formed (or manufactured) of the substantially opaque material. For example, the substrate 410 may include silicon. For example, the substrate 410 may be referred to as a silicon substrate. Since the substrate 410 may support various components of the display 400, the substrate 410 may be referred to as a base layer.

According to an embodiment, the light emitting layer 420 may be disposed over (or on) the substrate 410. For example, the light emitting layer 420 may be disposed over (or on) one surface 410a of the substrate 410. A first direction (e.g., +z direction) in which the one surface 410a of the substrate 410 faces may be substantially the same as a direction in which the display 400 emits light. According to an embodiment, the light emitting layer 420 may include a plurality of light emitting elements 421, a plurality of first electrodes 422, at least one second electrode 423, an organic layer 424, and/or a plurality of partition walls 425. For example, since the display 400 includes the substrate 410 formed of a silicon material and the light emitting layer 420 formed of an organic material, the display 400 may be referred to as organic light emitting diodes (OLED) on silicon (Si) (OLEDoS).

According to an embodiment, the plurality of light emitting elements 421 may be configured to emit light. For example, the plurality of light emitting elements 421 may be configured to emit light in the first direction (e.g., +z direction), which is the direction in which the one surface 410a of the substrate 410 faces. The number of the plurality of light emitting elements 421 may correspond to the number of subpixels 400-1, 400-2, and 400-3 in the display 400. The sub-pixels 400-1, 400-2, and 400-3 may emit light toward an outside of the display 400. For example, one subpixel for emitting red light, two subpixels for emitting green light, and/or one subpixel for emitting blue light may define (or form) each of the pixels of the display 400. Each of the plurality of light emitting elements 421 may be defined (or formed) by the plurality of first electrodes 422, the at least one second electrode 423, the organic layer 424, and/or the plurality of partition walls 425. For example, the plurality of light emitting elements 421 may be referred to as a plurality of light emitting portions, but are not limited thereto.

According to an embodiment, the plurality of first electrodes 422 may be disposed on (or over) the substrate 410. The plurality of first electrodes 422 may be electrically connected to, for example, the conductive lines 411 forming (or defining) at least a portion of the plurality of TFTs. The plurality of first electrodes 422 may be spaced apart from each other. For example, the plurality of first electrodes 422 may be spaced apart from each other along a second direction (e.g., +x direction and/or -x direction) substantially perpendicular to the first direction (e.g., +z direction). For example, the plurality of first electrodes 422 may be anodes. In case that the plurality of first electrodes 422 are anodes, the plurality of first electrodes 422 may transfer (or emit) a hole to the organic layer 424 by an electric field applied from the plurality of TFTs. However, it is not limited thereto. For example, the plurality of first electrodes 422 may be cathodes. According to an embodiment, the number of the plurality of first electrodes 422 may correspond to the number of subpixels 400-1, 400-2, and 400-3 included in the display 400. For example, the number of the plurality of first electrodes 422 may correspond to the number of the plurality of light emitting elements 421.

According to an embodiment, the at least one second electrode 423 may be disposed on (or over) the plurality of first electrodes 422. For example, the at least one second electrode 423 may be spaced apart from the plurality of first electrodes 422 along the first direction (e.g., +z direction). The at least one second electrode 423 may be disposed on (or over) the plurality of partition walls 425. The at least one second electrode 423 may extend along the plurality of partition walls 425. For example, the at least one second electrode 423 may have a shape extending along the second direction (e.g., +x direction and/or -x direction) substantially perpendicular to the first direction (e.g., +z direction). Meanwhile, in FIG. 4, the at least one second electrode 423 is illustrated as having a shape that does not include a step, but is not limited thereto. For example, the at least one second electrode 423 may have a shape corresponding to a shape (or disposition) of the plurality of partition walls 425. For example, the at least one second electrode 423 may be a cathode. In case that the at least one second electrode 423 is a cathode, the at least one second electrode 423 may transfer (or emit) an electron to the organic layer 424 by the electric field applied from the plurality of TFTs. However, it is not limited thereto. For example, the at least one second electrode 423 may be an anode.

According to an embodiment, the organic layer 424 may emit light based on energy generated by the electron and hole from the plurality of first electrodes 422 and the at least one second electrode 423. For example, the organic layer 424 may emit light in the first direction (e.g., +z direction) as the hole and electron transferred from each of the plurality of first electrodes 422 and the at least one second electrode 423 are transferred to the organic layer 424. The organic layer 424 may be disposed on (or over) the plurality of first electrodes 422. For example, the organic layer 424 may be interposed (or disposed) between the plurality of first electrodes 422 and the at least one second electrode 423. For example, the organic layer 424 may be in contact with the plurality of first electrodes 422. At least a portion of the organic layer 424 may be disposed on the plurality of partition walls 425. For example, a portion of the organic layer 424 may fill a space between the plurality of partition walls 425. For example, another portion of the organic layer 424 may be in contact with one surface of each of the plurality of partition walls 425 facing the first direction (e.g., +z direction). Meanwhile, in FIG. 4, the organic layer 424 is illustrated as having a shape that does not include a step, but is not limited thereto. For example, the organic layer 424 may have a shape corresponding to the shape (or disposition) of the plurality of partition walls 425. The organic layer 424 may be configured to emit light of a designated color. For example, the organic layer 424 may be configured to emit white light, but is not limited thereto. For example, the organic layer 424 may include portions disposed in each of the plurality of light emitting elements 421 by being disconnected from each other to emit light having blue, green, and/or red colors.

According to an embodiment, the plurality of partition walls 425 may define (or divide) subpixels 400-1, 400-2, and 400-3 in the display 400. At least a portion of each of the plurality of light emitting elements 421 may be disposed (or interposed) between the plurality of partition walls 425. For example, each of the plurality of partition walls 425 may define (or divide) the subpixels 400-1, 400-2, and 400-3 in the display 400 by surrounding at least a portion of the plurality of first electrodes 422. For example, the plurality of partition walls 425 may be referred to as a pixel define layer (PDL).

According to an embodiment, the encapsulation layer 430 may encapsulate the light emitting layer 420. For example, the encapsulation layer 430 may reduce (or block) inflow of a foreign substance (e.g., moisture) and/or oxygen into the plurality of light emitting elements 421. The encapsulation layer 430 may be disposed on the light emitting layer 420. For example, the encapsulation layer 430 may be in contact with the light emitting layer 420. For example, the encapsulation layer 430 may be disposed (or interposed) between the light emitting layer 420 and the plurality of transmission members 480. The encapsulation layer 430 may be formed of one or more inorganic films stacked on each other. For example, the encapsulation layer 430 may include one or more organic layers stacked on each other and one or more inorganic layers. For example, the encapsulation layer 430 may be referred to as a thin film encapsulation layer (TFE).

According to an embodiment, the filter layer 440 may be disposed (or interposed) between the encapsulation layer 430 and the plurality of transmission members 480. The filter layer 440 may include a plurality of color filters 441 and a plurality of first black matrixes (BMs) 442. The plurality of color filters 441 may change the color of light from each of the plurality of light emitting elements 421 passing through the plurality of color filters 441. For example, each of the plurality of color filters 441 may change the white light transferred from each of the plurality of light emitting elements 421 into one of the red light, blue light, and/or green light. Each of the plurality of color filters 441 may correspond to each of the plurality of light emitting elements 421. Each of the plurality of color filters 441 may be disposed on (or over) each of the plurality of light emitting elements 421. The plurality of color filters 441 may be spaced apart from the substrate 410 along the first direction (e.g., +z direction). The plurality of color filters 441 may be spaced apart from each other. For example, the plurality of color filters 441 may be spaced apart from each other along the second direction (e.g., +x direction and/or -x direction) substantially perpendicular to the first direction (e.g., +z direction). Each of the plurality of first BMs 442 may absorb a portion of light from each of the plurality of light emitting elements 421. For example, each of the plurality of first BMs 442 may be formed of a substantially opaque material. For example, each of the plurality of first BMs 442 may be formed of a material (e.g., a black-based material) for absorbing light. The plurality of first BMs 442 may define (or divide) each of the subpixels 400-1, 400-2, and 400-3. The plurality of first BMs 442 may be disposed between the plurality of color filters 441. The plurality of first BMs 442 may be spaced apart from each other. For example, the plurality of first BMs 442 may be spaced apart from each other along the second direction (e.g., +x direction and/or -x direction) substantially perpendicular to the first direction (e.g., +z direction).

According to an embodiment, the flattening layer 450 may compensate (or remove) a step on the filter layer 440. The flattening layer 450 may be disposed on the filter layer 440. For example, the flattening layer 450 may be in contact with the filter layer 440. The flattening layer 450 may be formed of a substantially transparent material. For example, the flattening layer 450 may be referred to as a passivation layer, but is not limited thereto.

According to an embodiment, the adhesive layer 460 may be disposed (or interposed) between the flattening layer 450 and the cover layer 470. The adhesive layer 460 may be disposed on the plurality of transmission members 480. The adhesive layer 460 may cover (or surround) the plurality of transmission members 480. For example, the adhesive layer 460 may be formed of a substantially transparent material. For example, the adhesive layer 460 may be formed of an optically clear adhesive (OCA), but is not limited thereto.

According to an embodiment, the cover layer 470 may protect components in the display 400. For example, the cover layer 470 may be exposed to an outside of the display 400. In case that the cover layer 470 is exposed to the outside of the display 400, the cover layer 470 may define (or form) an outer surface of the display 400, but is not limited thereto. The cover layer 470 may be disposed on the adhesive layer 460. For example, the cover layer 470 may be in contact with the adhesive layer 460.

According to an embodiment, the plurality of light emitting elements 421 may include a plurality of first light emitting elements 421a and at least one second light emitting element 421b. The plurality of first light emitting elements 421a and the at least one second light emitting element 421b may be distinguished by an amount of light. For example, the plurality of first light emitting elements 421a may emit a first light having a first amount of light, and the at least one second light emitting element 421b may emit a second light having a second amount of light. The second light may be brighter than the first light due to a defect f1 in at least one of the substrate 410 and/or the light emitting layer 420. The at least one second light emitting element 421b may be disposed on (or over) the defect f1 in at least one of the substrate 410 and/or the light emitting layer 420. For example, the at least one second light emitting element 421b may emit the second light brighter than the first light from each of the plurality of first light emitting elements 421a due to a defect (e.g., impurity) on the substrate 410 and/or a short circuit of at least a portion of the conductive lines 411. For example, the at least one second light emitting element 421b may emit the second light brighter than the first light from each of the plurality of first light emitting elements 421a due to a defect in the organic layer 424 in the light emitting layer 420.

According to an embodiment, the plurality of transmission members 480 may transmit light from the plurality of light emitting elements 421. For example, the plurality of transmission members 480 may be formed of a substantially transparent material. Each of the plurality of transmission members 480 may be disposed on each of the plurality of light emitting elements 421. According to an embodiment, the plurality of transmission members 480 may include a plurality of first transmission members 481 and at least one second transmission member 482.

According to an embodiment, each of the plurality of first transmission members 481 may transmit the first light from each of the plurality of first light emitting elements 421a. Each of the plurality of first transmission members 481 may correspond to each of the plurality of first light emitting elements 421a. Each of the plurality of first transmission members 481 may be disposed on (or over) each of the plurality of first light emitting elements 421a. For example, each of the plurality of first transmission members 481 may be spaced apart from each of the plurality of first light emitting elements 421a along the first direction (e.g., +z direction). The plurality of first transmission members 481 may improve luminance of the plurality of first light emitting elements 421a. For example, each of the plurality of first transmission members 481 may refract (or focus) the first light from each of the plurality of first light emitting elements 421a so that the luminance of the first light from each of the plurality of first light emitting elements 421a is improved. The plurality of first transmission members 481 may have a shape for refracting (or focusing) the first light from each of the plurality of first light emitting elements 421a. For example, one surface of each of the plurality of first transmission members 481 in contact with the adhesive layer 460 may have a curved shape. For example, the one surface of each of the plurality of first transmission members 481 in contact with the adhesive layer 460 may have a convex shape with respect to the first direction (e.g., +z direction). The plurality of first transmission members 481 may be spaced apart from each other. For example, the plurality of first transmission members 481 may be referred to as a plurality of lenses.

According to an embodiment, the at least one second transmission member 482 may correspond to the at least one second light emitting element 421b. The at least one second transmission member 482 may be disposed on (or over) the at least one second light emitting element 421b. For example, the at least one second transmission member 482 may be spaced apart from the at least one second light emitting element 421b along the first direction (e.g., +z direction). The at least one second transmission member 482 may transmit the second light from the at least one second light emitting element 421b. The at least one second transmission member 482 may be formed of substantially the same material as the plurality of first transmission members 481. According to an embodiment, the at least one second transmission member 482 may be formed by cutting at least one of the plurality of transmission members 480. For example, the at least one second transmission member 482 may be formed by cutting at least one of the plurality of transmission members 480 by a laser. For example, the at least one second transmission member 482 may be formed as at least one of the plurality of transmission members 480 is carbonized by the laser. According to an embodiment, the at least one second transmission member 482 may have a shape different from of each of the plurality of first transmission members 481. For example, the at least one second transmission member 482 may have a volume different from each of the plurality of first transmission members 481. For example, a thickness of the at least one second transmission member 482 may be less than a thickness of each of the plurality of first transmission members 481. A thickness of one component may represent a distance in the first direction (e.g., +z direction), and the corresponding expression may be used substantially the same in the following unless otherwise specified.

According to an embodiment, the blocking member 490 may absorb at least a portion of the second light from the at least one second light emitting element 421b transferred to the outside of the display 400. The blocking member 490 may block the second light from the at least one second light emitting element 421b from being transferred to the outside of the display 400. For example, the blocking member 490 may include a substantially opaque material. The blocking member 490 may be formed of the substantially opaque material. The blocking member 490 may be formed of a material (e.g., the black-based material) for absorbing light. According to an embodiment, the blocking member 490 may remove a bright spot (e.g., the bright spot s1 of FIG. 3) visible from the outside of the display 400. For example, the blocking member 490 may remove the bright spot s1 visible from the outside of the display 400 by being disposed on (or over) the at least one second light emitting element 421b. For example, the blocking member 490 may overlap the at least one second light emitting element 421b when viewing the display 400 from above. For example, the blocking member 490 may at least partially overlap the at least one second light emitting element 421b when viewing the display 400 along a third direction (e.g., -z direction) opposite to the first direction (e.g., +z direction). For example, in case that the blocking member 490 is omitted, the second light from the at least one second light emitting element 421b positioned on the defect f1 may be emitted to the outside of the display 400. In case that the second light from the at least one second light emitting element 421b is emitted to the outside of the display 400, the subpixel 400-2 corresponding to a position of the at least one second light emitting element 421b may be visible as the bright spot s1 from the outside of the display 400. In case that the subpixel 400-2 is visible as the bright spot s1 from the outside of the display 400, the display 400 may cause inconvenience to a user. An electronic device (e.g., the electronic device 101 of FIG. 3) according to an embodiment may provide a structure in which the bright spot s1 visible from the outside of the display 400 is removed by the blocking member 490 that occludes the at least one second light emitting element 421b corresponding to the defect f1. The second light emitted from the at least one second light emitting element 421b may not be transferred (or emitted) to the outside of the display 400 by the blocking member 490. As the blocking member 490 blocks the second light emitted from the at least one second light emitting element 421b, the subpixel 400-2 corresponding to the at least one second light emitting element 421b may become a dark dot. One area of a screen (e.g., the screen 401 of FIG. 3) where the dark dot is positioned may be darker than another area of the screen 401 where the dark dot is not positioned. The brightness (or luminance) of one area of the screen 401 where the dark dot is positioned may be lower than the brightness (or luminance) of another area of the screen 401 where the dark dot is not positioned. Since the visibility of the dark dot is lower than the visibility of the bright spot s1, the blocking member 490 may change the bright spot s1 to the dark dot by occluding the at least one second light emitting element 421b.

According to an embodiment, the at least one second transmission member 482 may provide (or define) a space in which the blocking member 490 is disposed. For example, the blocking member 490 may be accommodated in the at least one second transmission member 482 formed by cutting at least one of the plurality of transmission members 480. The blocking member 490 may be in contact with the at least one second transmission member 482. The blocking member 490 may be accommodated (or disposed) in the at least one second transmission member 482. For example, at least a portion of the blocking member 490 may be surrounded (or covered) by the at least one second transmission member 482. For example, one surface 490a of the blocking member 490 facing the cover layer 470 may be exposed to an outside of the at least one second transmission member 482. The electronic device 101 according to an embodiment may provide a structure that facilitates removal of the bright spot s1 since the blocking member 490 for absorbing the second light from the at least one second light emitting element 421b is disposed in the at least one second transmission member 482. For example, in case that the substrate 410 is formed of an opaque material (e.g., silicon), the defect f1 on the one surface 410a of the substrate 410 may not be removed by irradiating the laser through another surface 410b of the substrate 410. The other surface 410b of the substrate 410 may be opposite to the one surface 410a of the substrate 410. For example, the third direction (e.g., -z direction) in which the other surface 410b of the substrate 410 faces may be opposite to the first direction (e.g., +z direction) in which the one surface 410a of the substrate 410 faces. The electronic device 101 according to an embodiment may provide a structure capable of easily removing the bright spot s1 visible from the outside of the display 400 since the at least one second transmission member 482 accommodating the blocking member 490 is formed by deforming one of the plurality of transmission members 480 corresponding to the defect f1.

According to an embodiment, the blocking member 490 may be at least partially inserted into the at least one second transmission member 482. The blocking member 490 may penetrate the at least one second transmission member 482. For example, the blocking member 490 may penetrate the at least one second transmission member 482, the flattening layer 450, and a portion of the filter layer 440. For example, the blocking member 490 may be inserted into at least a portion of one color filter 441a corresponding to the at least one second light emitting element 421b among the plurality of color filters 441. However, it is not limited thereto. For example, the blocking member 490 may penetrate the at least one second transmission member 482 and a portion of the flattening layer 450. The blocking member 490 may be spaced apart from the encapsulation layer 430. For example, in case that the blocking member 490 penetrates at least a portion of the encapsulation layer 430, the plurality of light emitting elements 421 in the light emitting layer 420 may be damaged as a foreign substance or oxygen flows into the light emitting layer 420. The electronic device 101 according to an embodiment may provide a structure capable of reducing damage to the display 400 due to the inflow of the foreign substance or oxygen into the light emitting layer 420 by the blocking member 490 disposed outside the encapsulation layer 430.

As described above, the electronic device 101 according to an embodiment may provide a structure capable of reducing a number of bright spots s1 visible from the outside of the display 400 by the blocking member 490 overlaid on the at least one second light emitting element 421b corresponding to a position of the defect f1.

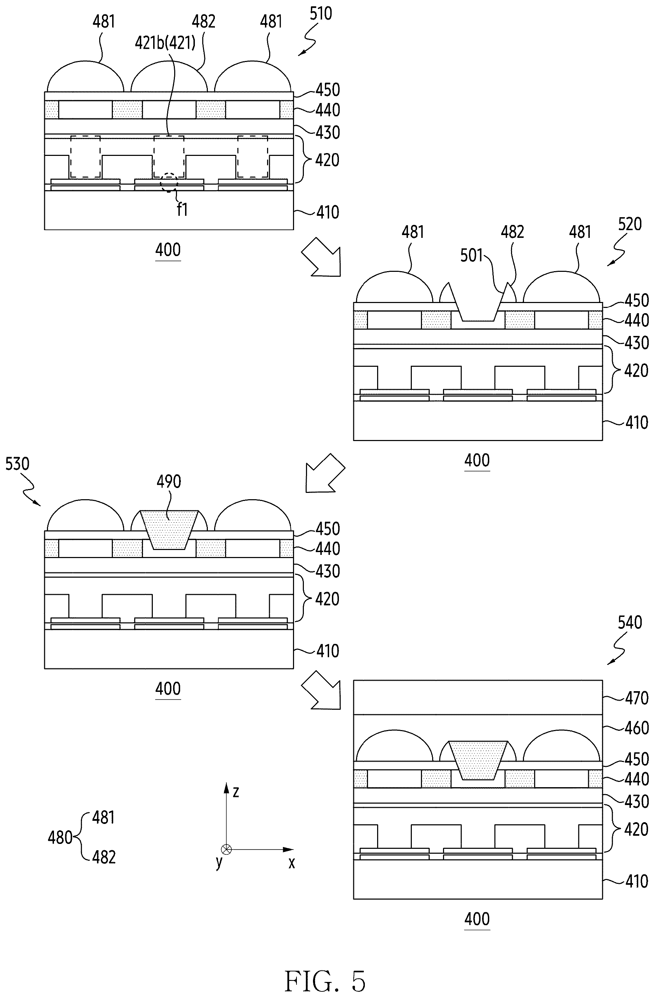

FIG. 5 illustrates an example of a method of manufacturing an exemplary display according to an embodiment.

Referring to FIG. 5, in a state 510, a light emitting layer 420 may be stacked on a substrate 410. An encapsulation layer 430 may be stacked on the light emitting layer 420. For example, the encapsulation layer 430 may be interposed between a plurality of first transmission members 481 and the light emitting layer 420, and between at least one second transmission member 482 and the light emitting layer 420. A filter layer 440 may be stacked on the encapsulation layer 430. For example, the filter layer 440 may be interposed between the encapsulation layer 430 and the plurality of first transmission members 481, and between the at least one second transmission member 482 and the encapsulation layer 430. A flattening layer 450 may be stacked on the filter layer 440. For example, the flattening layer 450 may be interposed between the filter layer 440 and the plurality of first transmission members 481, and between the filter layer 440 and the at least one second transmission member 482. A plurality of transmission members 480 may be stacked on the flattening layer 450. According to an embodiment, in the state 510, a position of a defect f1 may be identified. For example, the position of the defect f1 may be identified through the position of at least one second light emitting element 421b that emits brighter light than other light emitting elements among a plurality of light emitting elements 421.

In a state 520, a groove 501 may be formed. The position of the groove 501 may correspond to the position of the at least one second light emitting element 421b corresponding to the position of the defect f1. The groove 501 may be formed (or disposed) in one of the plurality of transmission members 480 (e.g., the at least one second transmission member 482) corresponding to the at least one second light emitting element 421b. The groove 501 may penetrate at least a portion of one of the plurality of transmission members 480, the flattening layer 450, and the filter layer 440. For example, the groove 501 may be formed by cutting one of the plurality of transmission members 480 by a laser, but is not limited thereto. For example, the groove 501 may be formed by cutting one of the plurality of transmission members 480 by a chemical solution or physical force. As one of the plurality of transmission members 480 is cut, the at least one second transmission member 482 may be formed.

In a state 530, a blocking member 490 may be disposed (or accommodated) inside the groove 501. The blocking member 490 may fill at least a portion of the groove 501. As the blocking member 490 fills at least a portion of the groove 501, the amount of second light from the at least one second transmission member 482 transferred to the outside of the display 400 may be reduced.

In a state 540, an adhesive layer 460 may be stacked on the plurality of transmission members 480 and the flattening layer 450. A cover layer 470 may be stacked on the adhesive layer 460. As the cover layer 470 is stacked, manufacturing of the display 400 may be completed.

As described above, a display according to an embodiment (e.g., the display 400 of FIG. 3) may provide a structure that facilitates removal of a bright spot (e.g., the bright spot s1 of FIG. 3) since the blocking member 490 is accommodated in the at least one second transmission member 482 formed by cutting one of the plurality of transmission members 480. For example, after the position of the defect f1 is identified, the removal of the bright spot s1 in a process of manufacturing the display 400 may be easy since the blocking member 490 is accommodated in a space in which one of the plurality of transmission members 480 corresponding to the position of the defect f1 is cut.

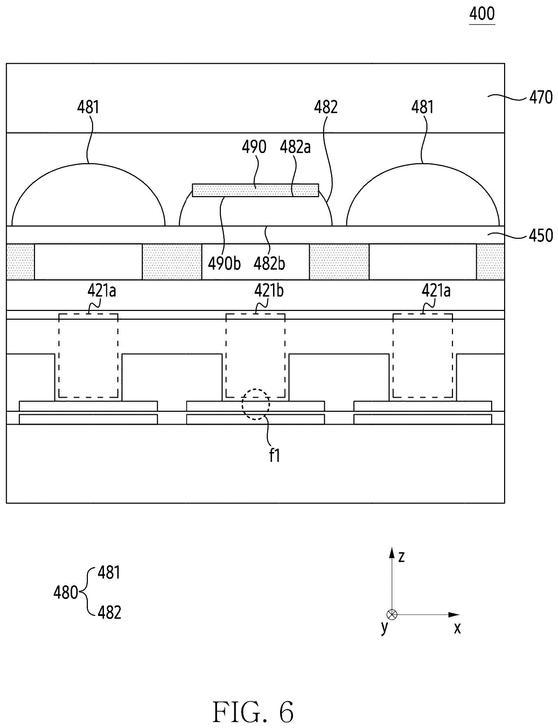

FIG. 6 is a cross-sectional view illustrating an example of cutting an exemplary display according to an embodiment.

Since a display 400 of FIG. 6 may be the display 400 in which a structure of a filter layer 440, a flattening layer 450, at least one second transmission member 482, and a blocking member 490 is changed in a display 400 of FIG. 4, overlapping descriptions will be omitted.

Referring to FIG. 6, according to an embodiment, one surface 482a of the at least one second transmission member 482 may have a shape substantially parallel to the flattening layer 450. For example, the one surface 482a of the at least one second transmission member 482 may have a substantially planar shape.

According to an embodiment, the blocking member 490 may be disposed on the at least one second transmission member 482. For example, the blocking member 490 may be disposed on the one surface 482a of the at least one second transmission member 482 facing a cover layer 470. The blocking member 490 may be disposed outside the flattening layer 450. The blocking member 490 may be spaced apart from the flattening layer 450. According to an embodiment, the blocking member 490 may be formed by carbonizing one of a plurality of transmission members 480 corresponding to a defect f1. For example, the blocking member 490 may be formed by carbonizing one of the plurality of transmission members 480 corresponding to the defect f1 by a laser, but is not limited thereto. For example, after one of the plurality of transmission members 480 corresponding to the defect f1 is cut, the blocking member 490 may be formed as a material for forming the blocking member 490 is disposed on one of the plurality of transmission members 480 corresponding to the defect f1.

According to an embodiment, the size of the at least one second transmission member 482 may be greater than the size of the blocking member 490. For example, the width of the at least one second transmission member 482 may be greater than the width of the blocking member 490. The width of one component may represent a distance in a second direction (e.g., +x direction or -x direction), and the corresponding expression may be used substantially the same hereinafter. For example, an area of another surface 482b of the at least one second transmission member 482 facing at least one second light emitting element 421b may be greater than an area of another surface 490b of the blocking member 490 facing the at least one second light emitting element 421b. For example, in case that the blocking member 490 is formed by carbonization of one of the plurality of transmission members 480 by the laser, the more one of the plurality of transmission members 480 is excessively carbonized, more heat may be transferred to a plurality of first transmission members 481. In case that the heat in a process of carbonizing one of the plurality of transmission members 480 is transferred to the plurality of first transmission members 481, a first light from each of a plurality of first light emitting elements 421a may not be refracted (or focused) since the plurality of first transmission members 481 are deformed by heat. In the display 400 according to an embodiment, deformation of the plurality of first transmission members 481 may be reduced (or inhibited) while the blocking member 490 is formed, since the blocking member 490 is formed by carbonizing one of the plurality of transmission members 480 corresponding to a position of the defect f1 within an appropriate range. Since one of the plurality of transmission members 480 corresponding to the position of the defect f1 is carbonized within the appropriate range, the size of the blocking member 490 may become smaller than the size of the at least one second transmission member 482.

As described above, the display 400 according to an embodiment may provide a structure capable of reducing the number of bright spots (e.g., the bright spots s1 of FIG. 3) visible from an outside of the display 400 by the blocking member 490 overlapping the at least one second light emitting element 421b.

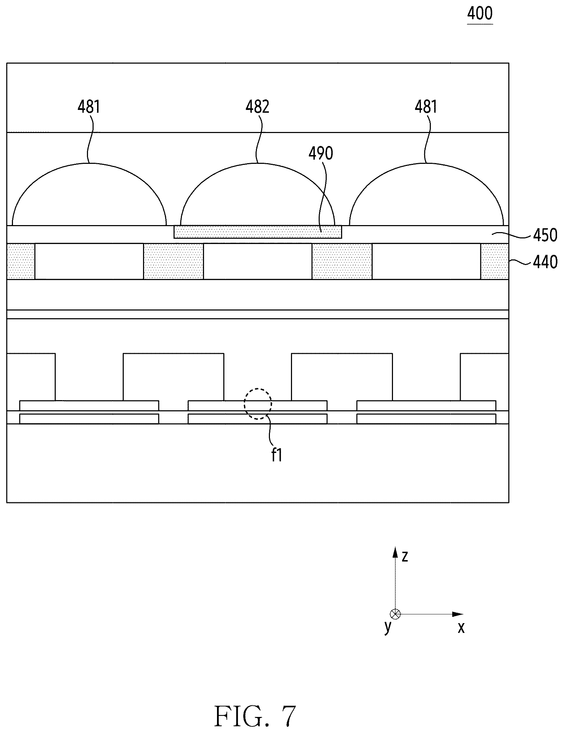

FIG. 7 is a cross-sectional view illustrating an example of cutting an exemplary display according to an embodiment.

A display 400 of FIG. 7 may be the display 400 in which a structure of a filter layer 440, a flattening layer 450, a plurality of transmission members 480, and a blocking member 490 is changed from a display 400 of FIG. 4, so overlapping descriptions will be omitted.

Referring to FIG. 7, according to an embodiment, a shape of at least one second transmission member 482 positioned on (or over) a defect f1 may be substantially the same as a shape of each of a plurality of first transmission members 481. A volume of the at least one second transmission member 482 positioned on (or over) the defect f1 may be substantially the same as a volume of each of the plurality of first transmission members 481.

According to an embodiment, the blocking member 490 may be disposed (or interposed) between the at least one second transmission member 482 and the filter layer 440. The blocking member 490 may be disposed in the flattening layer 450. For example, the blocking member 490 may be in contact with the at least one second transmission member 482 in the flattening layer 450. The blocking member 490 may be inserted into the flattening layer 450. For example, the blocking member 490 may be surrounded (or covered) by the flattening layer 450. A thickness of the blocking member 490 may be thinner than a thickness of the flattening layer 450, but is not limited thereto. For example, the thickness of the blocking member 490 may be substantially the same as the thickness of the flattening layer 450.

According to an embodiment, the blocking member 490 may be formed by cutting the flattening layer 450. For example, before the plurality of transmission members 480 are disposed, the flattening layer 450 may be cut after a position of the defect f1 is identified. After the flattening layer 450 is cut, the blocking member 490 may be formed as a material for forming the blocking member 490 is accommodated in the cut flattening layer 450. However, it is not limited thereto. The blocking member 490 may be formed by carbonization of the flattening layer 450. For example, before the plurality of transmission members 480 are disposed, the blocking member 490 may be formed as the flattening layer 450 is carbonized, after the position of the defect f1 is identified. For example, the carbonization of the flattening layer 450 may be performed by the laser. After the blocking member 490 is formed, manufacturing of the display 400 may be completed as the plurality of transmission members 480 are disposed on the flattening layer 450 and as an adhesive layer 460 and a cover layer 470 are each stacked.

As described above, the display 400 according to an embodiment may provide a structure capable of removing a bright spot visible from an outside of the display 400 by the blocking member 490 disposed in the flattening layer 450.

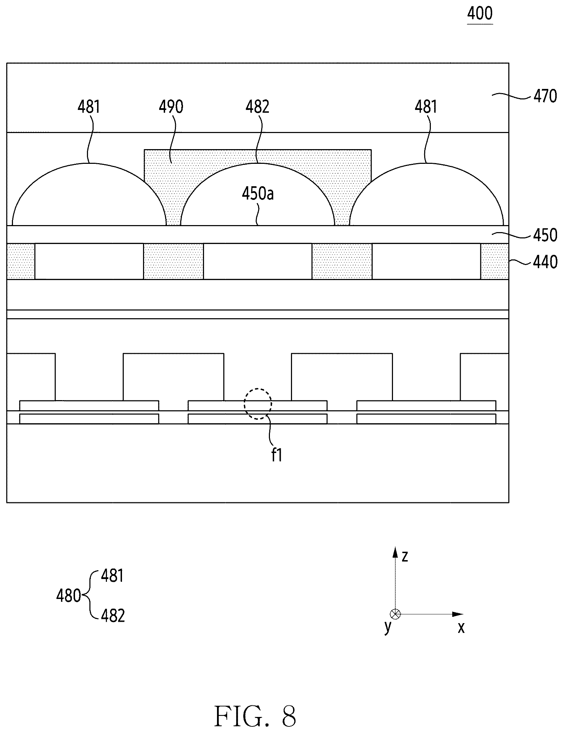

FIG. 8 is a cross-sectional view illustrating an example of cutting an exemplary display according to an embodiment.

A display 400 of FIG. 8 may be the display 400 in which a structure of a filter layer 440, a flattening layer 450, a plurality of transmission members 480, and a blocking member 490 is changed from a display 400 of FIG. 4, so overlapping descriptions will be omitted.

Referring to FIG. 8, according to an embodiment, a shape of at least one second transmission member 482 positioned on (or over) a defect f1 may be substantially the same as a shape of each of a plurality of first transmission members 481. A volume of the at least one second transmission member 482 positioned on (or over) the defect f1 may be substantially the same as a volume of each of the plurality of first transmission members 481.

According to an embodiment, the blocking member 490 may cover (or surround) the at least one second transmission member 482 and a portion of each of the plurality of first transmission members 481 adjacent to the at least one second transmission member 482. For example, the blocking member 490 may cover (or surround) a portion of each of the plurality of first transmission members 481 surrounding the at least one second transmission member 482. The blocking member 490 may be disposed on a portion of the flattening layer 450. For example, the blocking member 490 may be in contact with a portion of one surface 450a of the flattening layer 450 facing a cover layer 470.

According to an embodiment, the blocking member 490 may be formed after the plurality of transmission members 480 are formed. For example, after the plurality of transmission members 480 are formed, a position of the defect f1 may be identified. After the position of the defect f1 is identified, the blocking member 490 may be formed since a material for forming the blocking member 490 is disposed on the at least one second transmission member 482 and a portion of each of the plurality of first transmission members 481 adjacent to the at least one second transmission member 482.

As described above, the display 400 according to an embodiment may provide a structure capable of reducing the number of bright spots (e.g., the bright spot s1 of FIG. 3) visible from an outside of the display 400 by the blocking member 490 in contact with a portion of each of the at least one second transmission member 482 and the plurality of first transmission members 481.

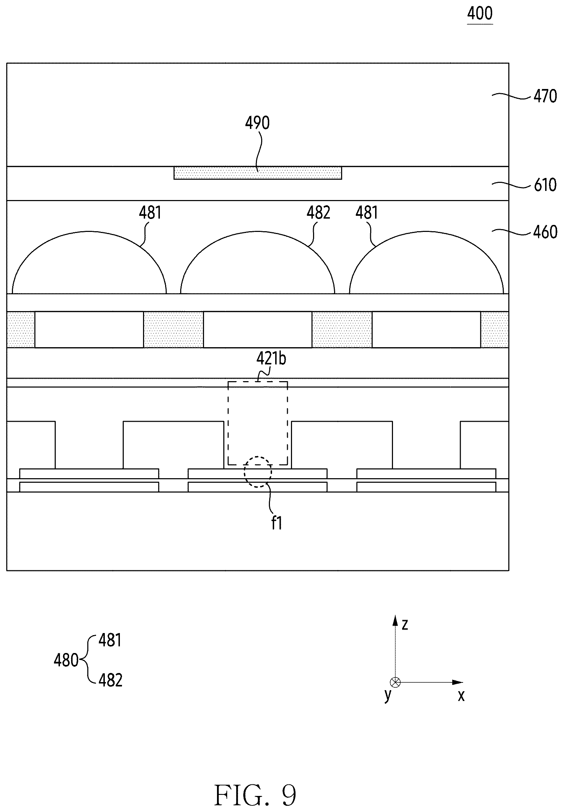

FIG. 9 is a cross-sectional view illustrating an example of cutting an exemplary display according to an embodiment.

A display 400 of FIG. 9 may be the display 400 in which a structure of a filter layer 440, a flattening layer 450, a plurality of transmission members 480, and a blocking member 490 is changed and a first compensation layer 610 is added, from a display 400 of FIG. 4, so overlapping descriptions will be omitted.

Referring to FIG. 9, according to an embodiment, a shape of at least one second transmission member 482 positioned on (or over) a defect f1 may be substantially the same as a shape of each of a plurality of first transmission members 481. A volume of the at least one second transmission member 482 positioned on (or over) the defect f1 may be substantially the same as a volume of each of the plurality of first transmission members 481.

According to an embodiment, the display 400 may further include the first compensation layer 610. The first compensation layer 610 may be disposed (or interposed) between an adhesive layer 460 and a cover layer 470. The first compensation layer 610 may be spaced apart from the plurality of transmission members 480. For example, the first compensation layer 610 may be spaced apart from the plurality of transmission members 480 along a first direction (e.g., +z direction).

According to an embodiment, the blocking member 490 may be disposed (or interposed) between the adhesive layer 460 and the cover layer 470. The blocking member 490 may be disposed (or interposed) between the at least one second transmission member 482 corresponding to a position of the defect f1 and the cover layer 470. The blocking member 490 may be disposed in the first compensation layer 610. For example, the blocking member 490 may be in contact with the cover layer 470 in the first compensation layer 610. The blocking member 490 may be inserted into the first compensation layer 610. For example, the blocking member 490 may be surrounded (or covered) by the first compensation layer 610. A thickness of the blocking member 490 may be thinner than a thickness of the first compensation layer 610, but is not limited thereto. For example, the thickness of the blocking member 490 may be substantially the same as the thickness of the first compensation layer 610. The first compensation layer 610 may be formed of, for example, at least one of a photosensitive polymer and/or a thermosensitive polymer.

According to an embodiment, the blocking member 490 may be formed after the first compensation layer 610 is formed. The first compensation layer 610 may be disposed (or formed) on the adhesive layer 460. After the first compensation layer 610 is disposed on the adhesive layer 460, the position of the defect f1 may be identified. For example, after the position of the defect f1 is identified, a laser may be irradiated to one area of the first compensation layer 610 corresponding to the position of the defect f1. The position of one area of the first compensation layer 610 corresponding to the position of the defect f1 may correspond to the position of at least one second light emitting element 421b. In case that the first compensation layer 610 is cut by irradiating a laser to one area of the first compensation layer 610, the blocking member 490 may be formed by accommodating a material for forming the blocking member 490 in one area of the cut first compensation layer 610. In case that the first compensation layer 610 is carbonized by irradiating the laser to one area of the first compensation layer 610, one area of the carbonized first compensation layer 610 may form a blocking member 490. After the blocking member 490 is formed, manufacturing of the display 400 may be completed as the cover layer 470 is disposed on the first compensation layer 610. However, it is not limited thereto. For example, the blocking member 490 may be formed after the cover layer 470 is disposed on the first compensation layer 610.

As described above, the display 400 according to an embodiment may provide a structure in which a bright spot (e.g., the bright spot s1 of FIG. 3) caused by the defect f1 is removed by the blocking member 490 disposed in the first compensation layer 610.

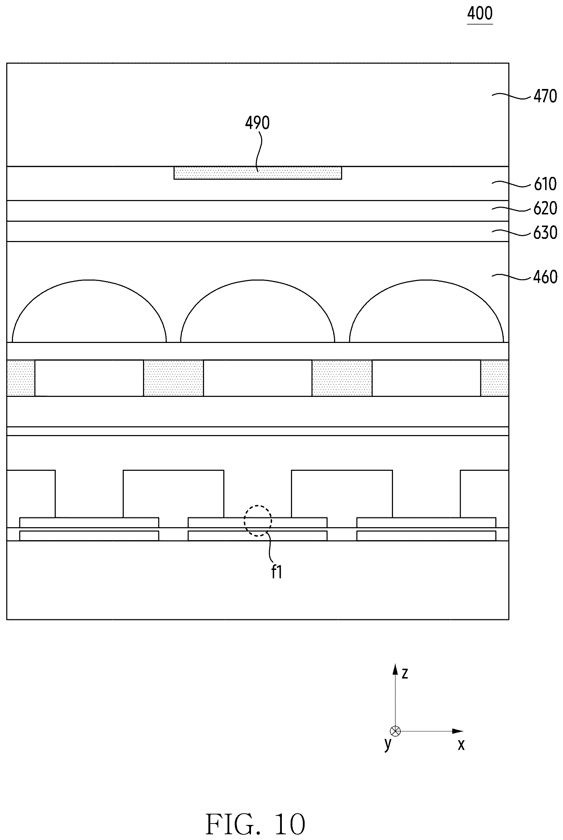

FIG. 10 is a cross-sectional view illustrating an example of cutting an exemplary display according to an embodiment.

A display 400 of FIG. 10 may be the display 400 in which a second compensation layer 620 and a third compensation layer 630 are added to a display 400 of FIG. 9, so overlapping descriptions will be omitted.

Referring to FIG. 10, according to an embodiment, the second compensation layer 620 may be disposed (or interposed) between a first compensation layer 610 and an adhesive layer 460. For example, the second compensation layer 620 may be disposed (or interposed) between the first compensation layer 610 and the third compensation layer 630. The second compensation layer 620 may reduce (or block) the transfer of heat generated by a laser for forming a blocking member 490 to the adhesive layer 460. The second compensation layer 620 may be formed of a material whose properties are not changed by the laser. For example, the second compensation layer 620 may be formed of at least one of an inorganic material and an organic material. For example, the second compensation layer 620 may be formed of a substantially transparent material, but is not limited thereto.

According to an embodiment, the third compensation layer 630 may be disposed (or interposed) between the second compensation layer 620 and the adhesive layer 460. The third compensation layer 630 may reduce (or block) the transfer of the laser for forming the blocking member 490 to the adhesive layer 460. The third compensation layer 630 may be formed of a material whose properties are not changed by the laser. For example, the third compensation layer 630 may be formed of a substantially transparent material. For example, the third compensation layer 630 may be formed of an inorganic material. For example, the third compensation layer 630 may be formed of at least one of Indium Tin Oxide (ITO) and Indium Zinc Oxide (IZO), but is not limited thereto.

According to an embodiment, after the adhesive layer 460 is formed, the third compensation layer 630 may be stacked on the adhesive layer 460. After the third compensation layer 630 is formed, the second compensation layer 620 may be stacked on the third compensation layer 630. After the second compensation layer 620 is formed, the first compensation layer 610 may be stacked on the third compensation layer 630. After the first compensation layer 610 is formed, a position of a defect f1 may be identified. After the position of the defect f1 is identified, the blocking member 490 may be formed by laser irradiation. The second compensation layer 620 and the third compensation layer 630 may prevent the heat from the laser from being transferred to the adhesive layer 460 while the laser for forming the blocking member 490 is irradiated to the first compensation layer 610. After the blocking member 490 is formed, a cover layer 470 may be disposed on the first compensation layer 610 and the blocking member 490.

As described above, the display 400 according to an embodiment may provide a structure in which a bright spot (e.g., the bright spot s1 of FIG. 3) caused by the defect f1 is removed by the blocking member 490 disposed in the first compensation layer 610.

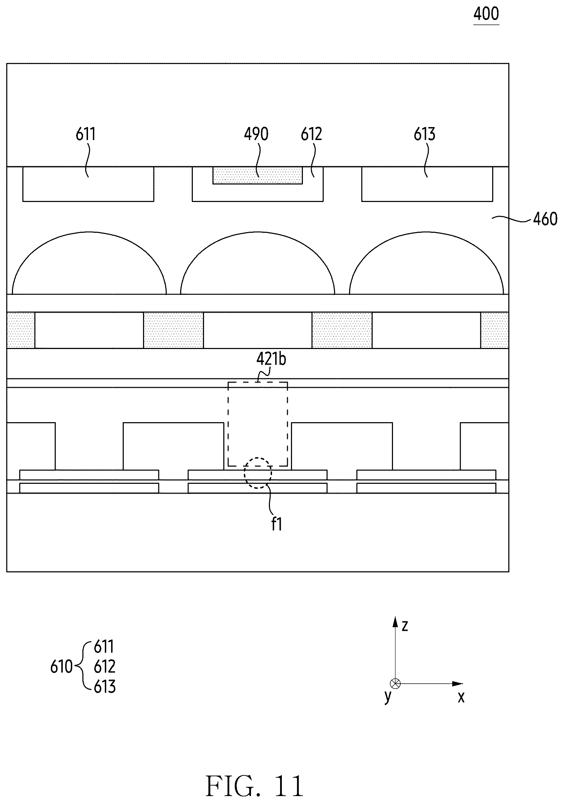

FIG. 11 is a cross-sectional view illustrating an example of cutting an exemplary display according to an embodiment.

A display 400 of FIG. 11 may be the display 400 in which a structure of a first compensation layer 610 is changed from a display 400 of FIG. 9, so overlapping descriptions will be omitted.

Referring to FIG. 11, according to an embodiment, the first compensation layer 610 may include portions 611, 612, and 613 disconnected from each other. Each of the portions 611, 612, and 613 of the first compensation layer 610 may correspond to each of a plurality of light emitting elements 421. The portions 611, 612, and 613 of the first compensation layer 610 may be disposed on each of the plurality of light emitting elements 421. The portions 611, 612, and 613 of the first compensation layer 610 may be spaced apart from each other. For example, the portions 611, 612, and 613 of the first compensation layer 610 may be spaced apart from each other along a second direction (e.g., +x direction and/or -x direction) substantially perpendicular to a first direction (e.g., +z direction). An adhesive layer 460 may fill a space between the portions 611, 612, and 613 of the first compensation layer 610.

According to an embodiment, a blocking member 490 may be disposed in the portion 612 corresponding to a position of a defect f1 among the portions 611, 612, and 613 of the first compensation layer 610. The blocking member 490 may be disposed in the portion 612 positioned on at least one second light emitting element 421b among the portions 611, 612, and 613 of the first compensation layer 610.

According to an embodiment, after the first compensation layer 610 is formed, the blocking member 490 may be formed. A laser for forming the blocking member 490 may be irradiated to the portion 612 corresponding to the position of the defect f1. Since the first compensation layer 610 has a disconnected shape, the amount of heat from the portion 612 transferred to the other portions 612 and 613 may be reduced.

As described above, the display 400 according to an embodiment may provide a structure in which a bright spot (e.g., the bright spot s1 of FIG. 3) is removed by the blocking member 490 disposed in the portion 612 of the first compensation layer 610 corresponding to the position of the defect f1.

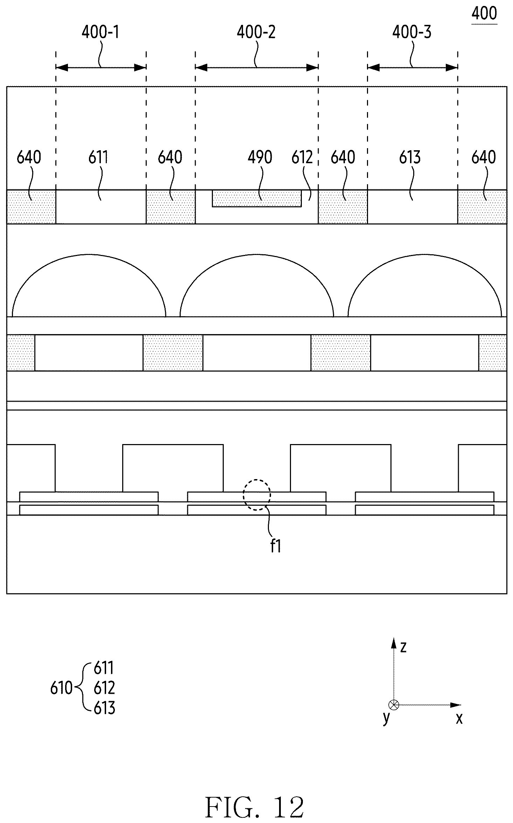

FIG. 12 is a cross-sectional view illustrating an example of cutting an exemplary display according to an embodiment.

A display 400 of FIG. 12 may be the display 400 in which a plurality of second BMs 640 is added to a display 400 of FIG. 11, so overlapping descriptions will be omitted.

Referring to FIG. 12, according to an embodiment, the plurality of second BMs 640 may divide (or define) a plurality of subpixels 400-1, 400-2, and 400-3. For example, the plurality of second BMs 640 may be formed of a material for absorbing light. The plurality of second BMs 640 may be spaced apart from each other. For example, the plurality of second BMs 640 may be spaced apart from each other along a second direction (e.g., +x direction and/or -x direction) substantially perpendicular to a first direction (e.g., +z direction). The plurality of second BMs 640 may be disposed (or interposed) between portions 611, 612, and 613 of a first compensation layer 610.

According to an embodiment, the blocking member 490 may be disposed in the portion 612 of the first compensation layer 610 corresponding to a position of a defect f1. The blocking member 490 may be spaced apart from each of the plurality of second BMs 640 covering (or surrounding) the portion 612 of the first compensation layer 610, but is not limited thereto. For example, the blocking member 490 may be in contact with each of the plurality of second BMs 640 covering (or surrounding) the portion 612 of the first compensation layer 610.

According to an embodiment, the plurality of second BMs 640 may be formed to accurately divide the plurality of subpixels 400-1, 400-2, and 400-3. In case that the plurality of second BMs 640 is omitted, for example, heat caused by a laser irradiated to the portion 612 of the first compensation layer 610 may be transferred to an adhesive layer 460 covering the portion 612 of the first compensation layer 610. In case that heat is transferred to the adhesive layer 460, it may be difficult to accurately divide the plurality of subpixels 400-1, 400-2, and 400-3. The display 400 according to an embodiment may include the plurality of subpixels 400-1, 400-2, and 400-3 that are relatively accurately divided since the plurality of second BMs 640 fill a gap between the portions 611, 612, and 613 of the first compensation layer 610.

As described above, the display 400 according to an embodiment may provide a structure in which a bright spot (e.g., the bright spot s1 of FIG. 3) is removed by the blocking member 490 disposed in the portion 612 of the first compensation layer 610 corresponding to the position of the defect f1.

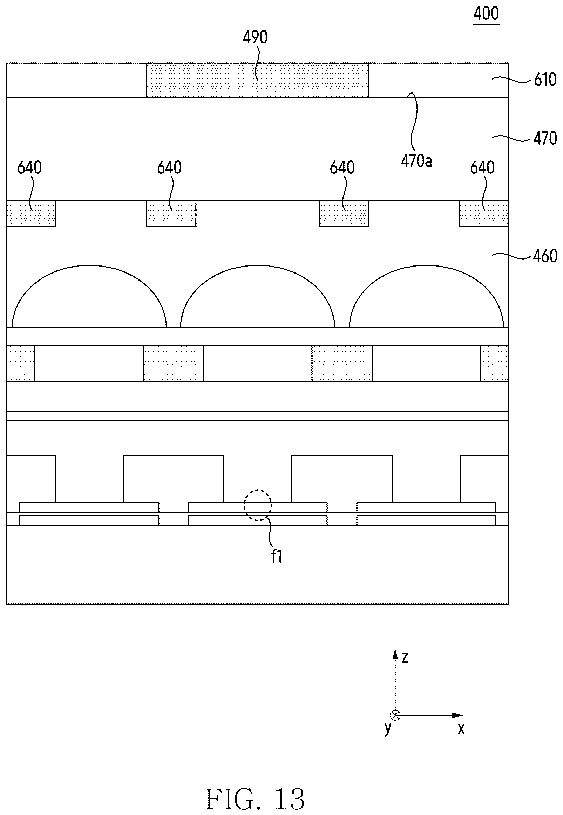

FIG. 13 is a cross-sectional view illustrating an example of cutting an exemplary display according to an embodiment.

A display 400 of FIG. 13 may be the display 400 in which a position of a first compensation layer 610 is changed from the display 400 of FIG. 9 and a plurality of second BMs 640 are added, so overlapping descriptions will be omitted.

Referring to FIG. 13, according to an embodiment, the plurality of second BMs 640 may be disposed (or inserted) in an adhesive layer 460. For example, the plurality of second BMs 640 may be in contact with a cover layer 470 in the adhesive layer 460, but is not limited thereto.

According to an embodiment, the first compensation layer 610 may be disposed on the cover layer 470. For example, the first compensation layer 610 may be disposed on one surface 470a of the cover layer 470 facing a first direction (e.g., +z direction). The blocking member 490 may be disposed on the one surface 470a of the cover layer 470 together with the first compensation layer 610 as the first compensation layer 610 is disposed on the cover layer 470.

As described above, the display 400 according to an embodiment may provide a structure capable of hiding a bright spot (e.g., the bright spot s1 of FIG. 3) caused by a defect f1 by the blocking member 490 disposed over the cover layer 470.

In a process of manufacturing a display of an electronic device, a bright spot of the display may be generated due to a defect on a substrate. The bright spot may be generated by a foreign substance on the substrate or a short circuit of a conductive pattern on the substrate. In case that the bright spot is generated in the display, a portion (or pixel) of the display including the bright spot may emit relatively bright light compared to another portion (or another pixel) of the display that does not include the bright spot. In case that the portion of the display emits brighter light than the other portion of the display, the display may not be able to smoothly provide visual information to a user. The electronic device may require a structure to compensate for the bright spot of the display.

Technical tasks to be achieved in the present disclosure are not limited to the technical tasks mentioned above, and other technical tasks not mentioned will be clearly understood by those having ordinary knowledge in the art to which the present disclosure belongs from the description below.

A display (e.g., the display 400 of FIG. 4) is provided. According to an embodiment, the display may comprise a substrate (e.g., the substrate 410 of FIG. 4). According to an embodiment, the display may comprise a plurality of first light emitting elements (e.g., the plurality of first light emitting elements 421a of FIG. 4) and at least one second light emitting element (e.g., the at least one second light emitting element 421b of FIG. 4) and may be disposed on each of a light emitting layer (e.g., the light emitting layer 420 of FIG. 4) disposed on the substrate and the plurality of first light emitting elements. According to an embodiment, the display may comprise a plurality of first transmission members (e.g., the plurality of first transmission members 481 of FIG. 4) configured to refract a first light from each of the plurality of first light emitting elements. According to an embodiment, the display may comprise at least one second transmission member (e.g., the at least one second transmission members 482 of FIG. 4) disposed on the at least one second light emitting element and configured to transmit a second light from the at least one second light emitting element. According to an embodiment, the display may comprise a blocking member (e.g., the blocking member 490 of FIG. 4) including opaque material for absorb at least a portion of the second light transferred to an outside of the display and contacting the at least one second transmission member. According to an embodiment, a shape of the at least one second transmission member may be different from a shape of each of the plurality of first transmission members.

According to an embodiment, the display may provide a structure in which a bright spot visible from the outside of the display is removed by a blocking member overlapping the at least one second light emitting element.

According to an embodiment, the second light may become brighter than the first light by a defect in the at least one of the substrate and the light emitting layer.

According to an embodiment, the display may provide a structure in which a bright spot formed by a defect in manufacturing of the display is removed by a blocking member overlapping the at least one second light emitting device.

According to an embodiment, the substrate may be formed of opaque material.

The display according to an embodiment may provide a structure capable of removing a bright spot caused by a defect over an opaque substrate by at least one second transmission member accommodating a blocking member.

According to an embodiment, the substrate may include silicone.

The display according to an embodiment may provide a structure capable of removing a bright spot caused by a defect on a silicon substrate by at least one second transmission member accommodating a blocking member.

According to an embodiment, at least a portion of the blocking member may be surrounded by the at least one second transmission member.

According to an embodiment, the display may provide a structure capable of removing a bright spot caused by a defect on a substrate by a blocking member at least partially inserted into at least one second transmission member.

According to an embodiment, the blocking member may be at least partially inserted in the at least one second transmission member.

According to an embodiment, since at least a portion of a blocking member is inserted into at least one second transmission member, the display may provide a structure capable of removing a bright spot caused by a defect on a substrate.

According to an embodiment, the display may comprise an encapsulation layer (e.g., the encapsulation layer 430 of FIG. 4) interposed between the light emitting layer and the plurality of first transmission members, and between the light emitting layer and the at least one second transmission member. According to an embodiment, the display may further comprise a filter layer (e.g., the filter layer 440 of FIG. 4) interposed between the encapsulation layer and the plurality of first transmission members, and between the encapsulation layer and the at least one second transmission member. According to an embodiment, the filter layer may include a plurality of color filters (e.g., the plurality of color filters 441 of FIG. 4) corresponding to each of the plurality of first light emitting elements and the at least one second light emitting element. According to an embodiment, the filter layer may include a plurality of BMs (e.g., the plurality of first BMs 442 of FIG. 4) disposed between the plurality of color filters. According to an embodiment, the blocking member may be inserted in at least a portion of one color filter corresponding to the at least one second light emitting element among the plurality of color filters.

According to an embodiment, the display may provide a structure capable of removing a bright spot caused by a defect on a substrate by a blocking member penetrating at least one second transmission member.

According to an embodiment, the blocking member may be spaced apart from the encapsulation layer.

The display according to an embodiment may provide a structure in which damage in the display is reduced since a blocking member is spaced apart from an encapsulation layer.

According to an embodiment, the display may further comprise a flattening layer (e.g., the flattening layer 450 of FIG. 4) interposed between the filter layer and the plurality of first transmission members, and between the filter layer and the at least one second transmission member. According to an embodiment, the blocking member may penetrate the flattening layer.

The display according to an embodiment may provide a structure capable of removing a bright spot caused by a defect on a substrate by a blocking member penetrating the flattening layer.

According to an embodiment, the blocking member may overlap the at least one second light emitting element when viewing the display from above.

The display according to an embodiment may provide a structure capable of removing a bright spot caused by a defect on a substrate by a blocking member overlapping at least one second light emitting element positioned at a position corresponding to a position of the defect.

According to an embodiment, a thickness of the at least one second transmission member may be smaller than a thickness of each of the plurality of first transmission members.

The display according to an embodiment may provide a structure in which a bright spot may be easily removed by at least one second transmission member formed by cutting one of a plurality of transmission members.

According to an embodiment, the light emitting layer may include a plurality of first electrodes (e.g., the plurality of first electrodes 422 of FIG. 4) spaced apart from each other. According to an embodiment, the light emitting layer may include a plurality of partition walls (e.g., the plurality of partition walls 425 of FIG. 4) surrounding the plurality of first electrodes. According to an embodiment, the light emitting layer may include an organic layer (e.g., the organic layer 424 of FIG. 4) including organic light emitting material and disposed on the plurality of first electrodes. According to an embodiment, the light emitting layer may include a second electrode (e.g., the second electrode 423 of FIG. 4) disposed on the organic layer.

The display according to an embodiment may provide a user with various visual information through a plurality of first electrodes corresponding to each other, at least one second electrode, and an organic layer.

According to an embodiment, the display may comprise a plurality of conductive lines (e.g., the plurality of conductive lines 411 of FIG. 4) interposed between the light emitting layer and the substrate.

According to an embodiment, the organic layer may fill at least a portion of a space between the plurality of partition walls.

According to an embodiment, an area of one surface (e.g., the one surface 482a of FIG. 5) of the at least one second transmission member facing the at least one second light emitting element may be greater than an area of one surface of the blocking member facing the at least one second light emitting element.

An electronic device (e.g., the electronic device of FIG. 3) is provided. According to an embodiment, the electronic device may comprise a housing (e.g., the housing 300 of FIG. 3). According to an embodiment, the electronic device may comprise a display (e.g., the display 400 of FIG. 4) disposed on the housing. According to an embodiment, the display may include a substrate (e.g., the substrate 410 of FIG. 4). According to an embodiment, the display may include a plurality of first light emitting elements (e.g., the plurality of first light emitting elements 421a of FIG. 4) and at least one second light emitting element (e.g., the at least one second light emitting element 421b of FIG. 4), and disposed on each of a light emitting layer (e.g., the light emitting layer 420 of FIG. 4) disposed on the substrate and the plurality of first light emitting elements. According to an embodiment, the display may include a plurality of first transmission members (e.g., the plurality of first transmission members 481 of FIG. 4) configured to refract a first light from each of the plurality of first light emitting elements. According to an embodiment, the display may include at least one second transmission member (e.g., the at least one second transmission member 482 of FIG. 4) disposed on the at least one second light emitting element and configured to transmit a second light from the at least one second light emitting element. According to an embodiment, the display may include a blocking member (e.g., the blocking member 490 of FIG. 4) including opaque material for absorb at least a portion of the second light transferred to an outside of the display and contacting the at least one second transmission member. According to an embodiment, a volume of the at least one second transmission member may be different from a volume of each of the plurality of first transmission members.

According to an embodiment, at least a portion of the blocking member may be surrounded by the at least one second transmission member.

According to an embodiment, the display may provide a structure capable of removing a bright spot caused by a defect on a substrate by a blocking member inserted at least partially into at least one second transmission member.

According to an embodiment, the display may comprise an encapsulation layer (e.g., the encapsulation layer 430 of FIG. 4) interposed between the light emitting layer and the plurality of first transmission members, and between the light emitting layer and the at least one second transmission member. According to an embodiment, the display may further comprise a filter layer (e.g., the filter layer 440 of FIG. 4) interposed between the encapsulation layer and the plurality of first transmission members, and between the encapsulation layer and the at least one second transmission member. According to an embodiment, the filter layer may include a plurality of color filters (e.g., the plurality of color filters 441 of FIG. 4) corresponding to each of the plurality of first light emitting elements and the at least one second light emitting element. According to an embodiment, the filter layer may include a plurality of BMs (e.g., the plurality of BMs 442 of FIG. 4) disposed between the plurality of color filters. According to an embodiment, the blocking member may be inserted in at least a portion of one color filter corresponding to the at least one second light emitting element among the plurality of color filters.

According to an embodiment, a thickness of the at least one second transmission member may be smaller than a thickness of each of the plurality of first transmission members.

The display according to an embodiment may provide a structure in which a bright spot may be easily removed by at least one second transmission member formed by cutting one of a plurality of transmission members.

According to an embodiment, an area of one surface (e.g., the one surface 482a of FIG. 5) of the at least one second transmission member facing the at least one second light emitting element may be greater than an area of one surface of the blocking member facing the at least one second light emitting element.

Effects obtainable in the present disclosure are not limited to the effects mentioned above, and other effects not mentioned will be clearly understood by those having ordinary knowledge in the art to which the present disclosure belongs from the description below.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been shown and described with reference to various embodiments thereof, it will be understood by those skilled in the art that various changes in form and details may be made therein without departing from the spirit and scope of the disclosure as defined by the appended claims and their equivalents.

## Claims

1. A display (400) comprising:
a substrate (410);
a light emitting layer (420) disposed on the substrate (410), and including a plurality of first light emitting elements (421a), and at least one second light emitting element (421b);
a plurality of first transmission members (481) disposed on each of the plurality of first light emitting elements (421a), and configured to refract a first light from each of the plurality of first light emitting elements (421a);
at least one second transmission member (482) disposed on the at least one second light emitting element (421b), and configured to transmit a second light from the at least one second light emitting element (421b); and
a blocking member (490) including opaque material for absorbing at least a portion of the second light transmitted to an outside of the display (400), and contacting the at least one second transmission member (482),
wherein a shape of the at least one second transmission member (482) is different from a shape of each of the plurality of first transmission members (481).

2. The display (400) of claim 1, wherein, the second light becomes brighter than the first light by a defect in the at least one of the substrate (410) and the light emitting layer (420).

3. The display (400) of claim 1 or 2, wherein, the substrate (410) is formed of opaque material.

4. The display (400) of any one of claims 1 to 3, wherein, the substrate (410) includes silicone.

5. The display (400) of any one of claims 1 to 4, wherein at least a portion of the blocking member (490) is surrounded by the at least one second transmission member (482).

6. The display (400) of any one of claims 5, wherein, the blocking member (490) is at least partially inserted in the at least one second transmission member (482).

7. The display (400) of any one of claims 1 to 6 further comprising:
an encapsulation layer (430) interposed between the light emitting layer (420) and the plurality of first transmission members (481), and between the light emitting layer (420) and the at least one second transmission member (482); and
a filter layer (440) interposed between the encapsulation layer (430) and the plurality of first transmission members (481), and between the encapsulation layer (430) and the at least one second transmission member (482),
wherein the filter layer (440) includes:
a plurality of color filters (441) corresponding to each of the plurality of first light emitting elements (421a), and the at least one second light emitting element (421b); and
a plurality of BMs (442) disposed between the plurality of color filters (441),
wherein the blocking member (490) is inserted in at least a portion of one color filter corresponding to the at least one second light emitting element (421b) among the plurality of color filters (441).

8. The display (400) of claim 7, wherein the blocking member (490) is spaced apart from the encapsulation layer (430).

9. The display (400) of claim 7, further comprising:
a flattening layer (450) interposed between the filter layer (440) and the plurality of first transmission members (481), and between the filter layer (440) and the at least one second transmission member (482),
wherein the blocking member (490) penetrates the flattening layer (450).

10. The display (400) of any one of claims 1 to 9, wherein, the blocking member (490) overlaps the at least one second light emitting element (421b) when viewing the display (400) from above.

11. The display (400) of any one of claims 1 to 10, wherein, a thickness of the at least one second transmission member (482) is smaller than a thickness of each of the plurality of first transmission members (481).

12. The display (400) of any one of claims 1 to 11, wherein, the light emitting layer (420) includes:
a plurality of first electrodes (422) spaced apart from each other;
a plurality of partition walls (425) surrounding the plurality of first electrodes (422);
an organic layer including organic light emitting material, and disposed on the plurality of first electrodes (422); and
a second electrode (423) disposed on the organic layer.

13. The display (400) of claim 12, wherein the organic layer fills at least a portion of a space between the plurality of partition walls (425).

14. The display (400) of any one of claims 1 to 13, further comprising:
a plurality of conductive lines (411) interposed between the light emitting layer (420) and the substrate (410).

15. The display (400) of any one of claims 1 to 14, wherein an area of one surface of the at least one second transmission member (482) facing the at least one second light emitting element (421b) is greater than an area of one surface of the blocking member (490) facing the at least one second light emitting element (421b).
